# EUROPEAN PATENT APPLICATION

(11) **EP 0 534 627 A1**
(43) Date of publication of application: **31.03.1993**
(21) Application number: 92308069.1
(22) Date of filing: 04.09.1992
(51) Int. Cl.: H01L 27/06

(54) **Semiconductor element with determination of the switching timing**

(30) Priority: 17.09.1991 JP 235209/91
(71) Applicant: FUJI ELECTRIC CO. LTD., Kawasaki 210 (JP)
(72) Inventor: Nishimura, Takeyoshi, Matsumoto-city 390 (JP)
(74) Representative: Carmichael, David Andrew Halliday

(57) **Abstract**

The invention aims to reduce switching loss by making possible the detection of the current flowing into parasitic diodes, which is useful for adjusting the switching timing at a commutation.

When the parasitic diodes consist of a first region of a first conduction type in a semiconductor substrate, and a second region of a second conduction type formed on the surface layer of the substrate, a third region with the same conduction type, impurity concentration and depth as the second region is formed on the surface layer of the first region, while the current flowing into the parasitic diodes consisting of the first and the third regions is drawn out from the electrode making contact with the third region, thereby making it possible to measure the current and identify the current flowing into the parasitic diodes.

## Description

The present invention relates to a semiconductor element that is a semiconductor switching element used for a semiconductor converter device, with the existence of parasitic diodes composed of a region of a first conduction type and a region of a second conduction type formed internally on a semiconductor substrate.

In a semiconductor converter device for generating a shift in electric current or a commutation among elements by switching the semiconductor elements as the constituent elements, it is known to determine the switching timing by detecting the current flowing in parasitic diodes existing in the semiconductor substrate in order to reduce the switching loss. The parasitic diodes may consist of a region of the first conduction type and a channel region of the second conduction type formed in the surface layer thereof in the case of a voltage-driven, MOS-type semiconductor element, and may consist of a region of the first conduction type and the base region of the second conduction type formed in the surface layer thereof in the case of a current-driven, bipolar-type semiconductor element. Nevertheless, it is difficult to detect a current flowing in the parasitic diodes, hence the switching timing has hitherto been adjusted by confirming it with a circuit that has been assembled with semiconductor elements.

Confirming the switching timing by actually assembling a circuit as described above requires much labour. Therefore, the present invention is intended to provide a semiconductor element that can easily detect a current flowing in the parasitic diodes existing internally to the semiconductor substrate, and reduce the switching loss in the semiconductor converter device to half.

To achieve the above objective, the present invention uses a semiconductor element characterised in that a first region of the first conduction type is formed on a semiconductor substrate and a second region of the second conduction type is formed selectively in the surface layer of the first region, and an electrode making contact at least with the second region is disposed on the surface of the semiconductor substrate, whereby a third region with the same conduction type, impurity concentration and depth as the second region is formed selectively on the surface layer of the semiconductor substrate, while another electrode that makes contact with the third region is formed on the surface of the semiconductor substrate. The present invention is also effective for a MOS-type semiconductor element in which a fourth region of the first conduction type is formed on the surface layer of the second region, and gate electrodes arranged on the second region in the part located between the first region and the fourth region via an insulation film and a main electrode that commonly make contact with the first region and the third region are disposed, and also for a bipolar type semiconductor element in which electrodes making contact with the first region and the second region are disposed on the surface of the semiconductor substrate.

When an electric current starts flowing through the parasitic diodes as generated by the first region and the second region, with the main electrode on the rear of the MOS-type semiconductor element using part of the second region as the channel region applied with a voltage, a current corresponding to the aforementioned current begins to flow in the sensing diodes being formed by the third region and the first region, and having the same conduction type, impurity concentration and depth as in the second region. However, by taking out and measuring the current from an electrode independent of the electrode for the main element, it is possible to detect the current flowing in the parasitic diodes, thereby making it possible to determine the switching timing. The current operating the main MOS-type semiconductor element does not flow into the sensing diodes, and therefore has no effect whatsoever.

When an electric current starts flowing in the parasitic diodes as generated by the first region and the second region, with the electrode (collector electrode) at the rear of the bipolar-type semiconductor element, such as a transistor, using part of the second region as the base region applied with a voltage, a current corresponding to the aforementioned current begins to flow in the sensing diodes that have been formed by the third region and the first region, and that have the same conduction type, impurity concentration and depth as those for the second region. Thereafter, by taking out and measuring the current from an electrode independent from the electrode for the main element, it is possible to detect the current flowing in the parasitic diodes, thereby enabling the switching timing to be determined.

Embodiments of the invention will now be described in detail with reference to the accompanying drawings in which:
Figure 1 shows part of the vertical-type MOSFET according to one embodiment of the present invention, Figure 1a being a plan view, and Figure 1b being a cross-section cut along the A-A line in Figure 1a;
Figure 2 is a plan view of a vertical MOSFET chip according to an embodiment of the present invention;
Figure 3 is a plan view of a conventional vertical MOSFET chip;
Figure 4 shows part of the vertical-type MOSFET according to another embodiment of the present invention, Figure 4a being a plan view, and Figure 4b being a cross-section taken along the B-B line in Figure 4a;
Figure 5 shows part of a vertical-type MOSFET according to still another embodiment of the present invention, Figure 5a being a plan view, and Figure 5b being a cross-section taken along the C-C line in Figure 5a;
Figure 6 is a plan view of a bipolar transistor chip according to the present invention;
Figure 7 is a plan view of a conventional bipolar transistor chip;
Figure 8 shows part of a bipolar transistor according to one embodiment of the present invention, Figure 8a being a plan view, and Figure 8b being a cross section taken along the D-D line in Figure 8a;
Figure 9 shows part of a bipolar transistor according to another embodiment of the present invention, Figure 9a being a plan view, and Figure 9b being a cross-section taken along the E-E line in Figure 9a; and
Figure 10 shows part of a bipolar transistor according to yet another embodiment of the present invention, Figure 10a being a plan view, and Figure 10b being a cross section taken along the F-F line in Figure 10a.

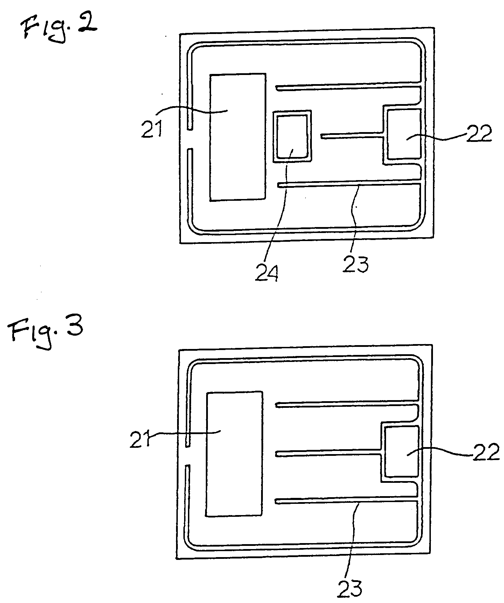

Explanations are given hereunder of the embodiments according to the present invention with reference to the drawings. Figure 2 is a plan view of a vertical-type MOSFET chip that is one embodiment of the present invention, and Figure 3 is a plan view of a conventional vertical-type MOSFET chip shown for the purpose of comparison. In both Figures, the source pad 21 connected to a source electrode and the gate pad 22 connected to a gate electrode via the gate runner 23 are disposed on the chip surface; however, in Figure 2 the parasitic diode sensing pad 24 is disposed beside the above components.

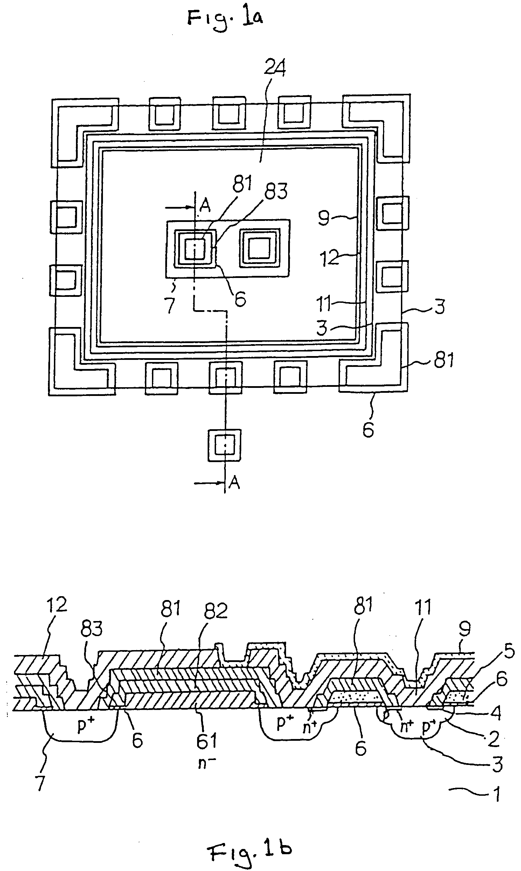

Figures 1a and 1b show the vicinity of the parasitic diode sensing pad 24, Figure 1a being its plan view and Figure 1b being a cross-section taken along the A-A line in Figure 1a.

The MOSFET cell located around the parasitic diode sensing pad 24 is constructed so that, as shown in Figure 1b, the p-type channel region 2 is selectively formed on the surface layer of the n⁻-type silicon substrate 1, as is the p⁺-type region 3 superimposed thereon, the n⁺ source regions 4 are selectively formed in the surface layers thereof, and the gate electrode 5 extending to the part located between the n⁺ region in the p⁻ region 2 and the exposed section of the substrate 1 is disposed via the gate oxide film 6. Sensing diodes are formed by the p⁺ anode region 7 formed simultaneously as the p⁺ region 3 in the region in which thick field oxide films 6 exist on the surface across the MOSFET section.

The source electrode 11 commonly making contact with the p⁺ region 3 and the n⁺ source region 4 is insulated by the gate electrode 6 and the PSG film 81, whereas the insulation B2 interposes beneath the PSG film 81 which insulates the anode electrode 12 that makes contact with the anode region 7 and is formed by Al deposition as in the case of the source electrode 11. The parasitic diode sensing pad 24 is formed on the face extended from this anode electrode 12. In addition, the SiN film 9 is deposited on the MOSFET cell for the purpose of passivation. Figure 1a shows the contours of each region, each electrode and each film.

Measuring the current flowing between the p-anode region 7 and the n⁻-substrate 1 using the anode electrode 12 enables the detection of the current flowing into the parasitic diodes formed by the p⁺-region 3 and the n⁻-substrate 1.

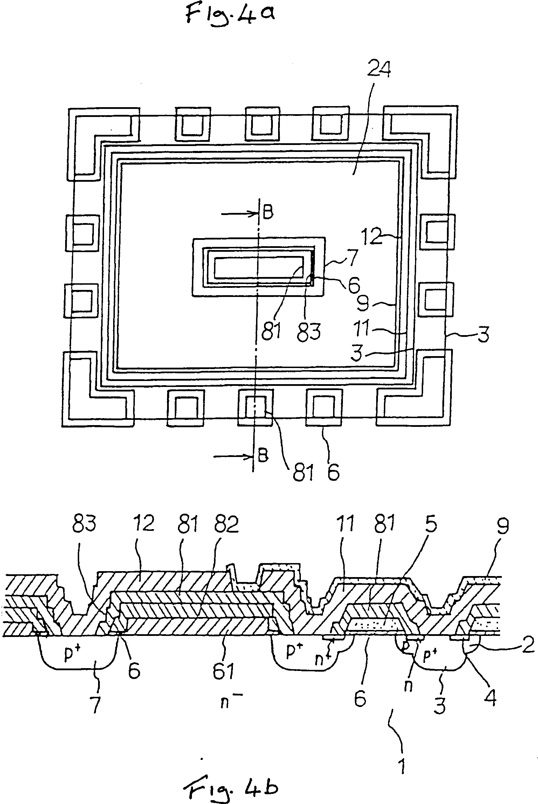

Figures 4a and 4b show the vicinity of the parasitic diode sensing pad 24 in the vertical MOSFET of another embodiment, the parts common with those in Figure 1 being given the same numerals. While there were two contact holes for the anode region 7 disposed in Figure 1, there is only one in this case.

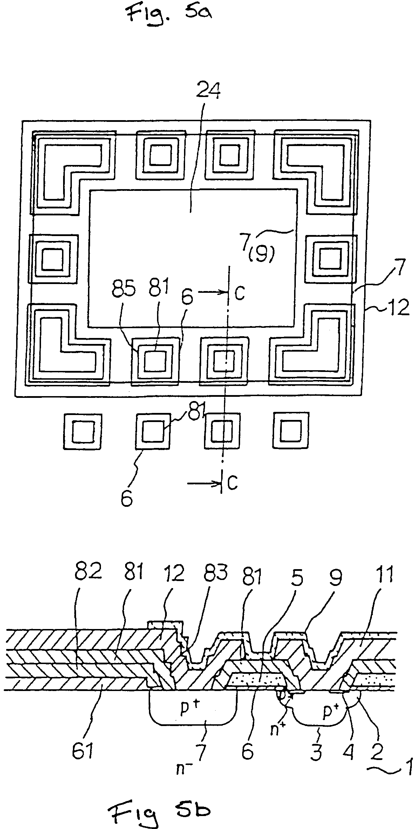

In the embodiment for the vertical MOSFET shown in Figures 5a and 5b, ten contact holes are disposed for the anode region 7. The present invention can therefore be applied not only to the above-mentioned MOSFET, but also to other MOS-type semiconductor elements, such as an IGBT, for example.

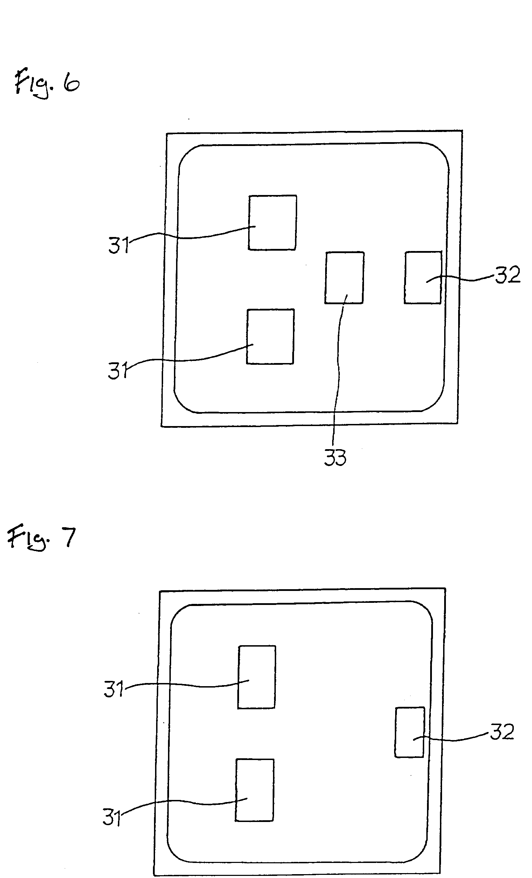

Figure 6 is a plan view of a mesh-type bipolar chip, which is another embodiment of the present invention, and Figure 7 is a plan view of a conventional mesh-type bipolar chip shown for the purpose of comparison. In the Figure, the emitter pad 31 connected to an emitter electrode and the base pad 32 connected to a base electrode are disposed on the chip surface; however, in Figure 6 the parasitic diode sensing pad 33 is disposed beside the above components.

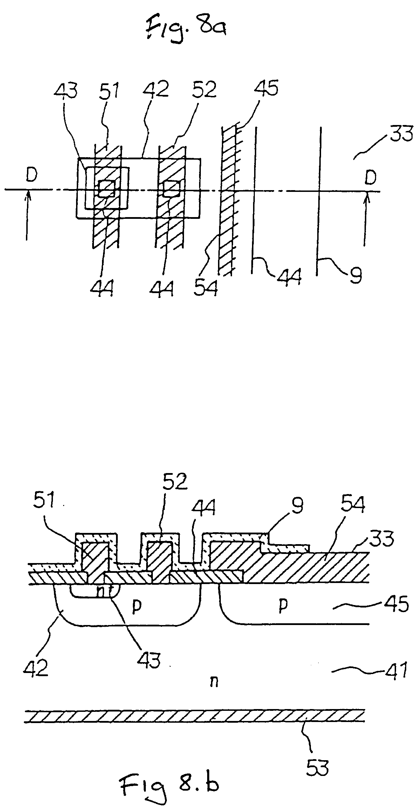

Figures 8a and 8b show the chip part in the vicinity of the parasitic diode sensing pad 33, Figure 8b being a cross-section taken along the D-D line in Figure 8a. Inside the surface layer of the p-base region 42 (of which only one is shown in Figure 6b among the many disposed) and selectively on the surface layer of the n-type silicon substrate 41, the n⁺-emitter region 43 is formed selectively, with each region in contact with the base electrode 52 and the emitter electrode 51 through the contact holes formed on the oxide film 44 deposited on the surface. These electrodes are covered with the SiN passivation film 9. Beneath the parasitic diode sensing pad, the anode region 45 for the sensing diode is formed simultaneously with the p-base region, the entire surface of the anode region being made to contact with the anode electrode 54. The electrodes 51, 52, and 54 are formed by patterning the Al deposited films, the top surface thereof being covered by the SiN passivation film 9, and the rear face of the substrate 41 being made to contact with the collector electrode 53. This collector electrode serves also as a cathode electrode for the sensing diodes.

Figure 8a shows the contours of each region, each electrode and each film. Measuring the current flowing between the p-anode region 45 and the n-substrate 41 using the anode electrode 54 and the cathode electrode 53 enables detection of the current flowing into the parasitic diode formed by the p-base region 42 and the n-substrate 41.

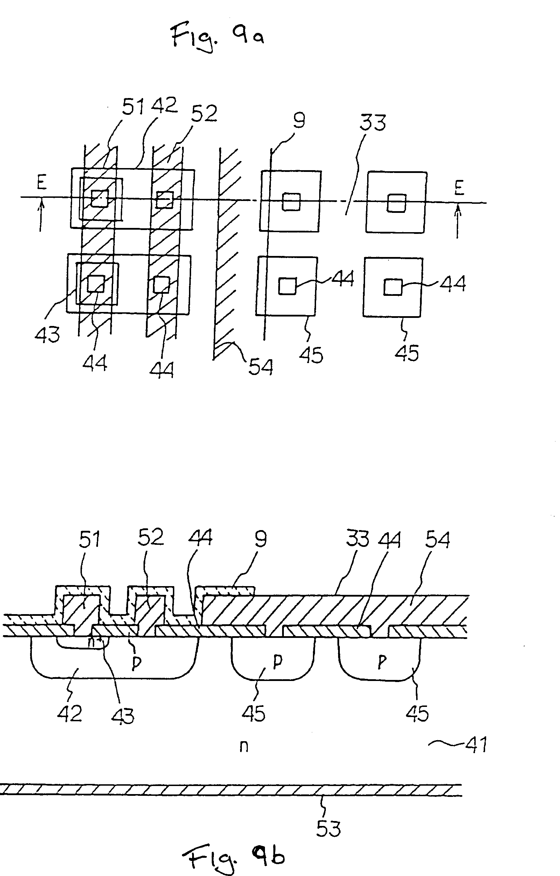

Figures 9a and 9b show the vicinity of the parasitic diode sensing pad 33 in the bipolar transistor of another embodiment, the parts common with those in Figure 8 being given the same numerals. In this case, the anode region 45 is formed simultaneously with the plural base region 42, and is made to contact through the contact holes formed on each surface of the anode electrodes 54, the parasitic diode sensing pad 33 being present on it.

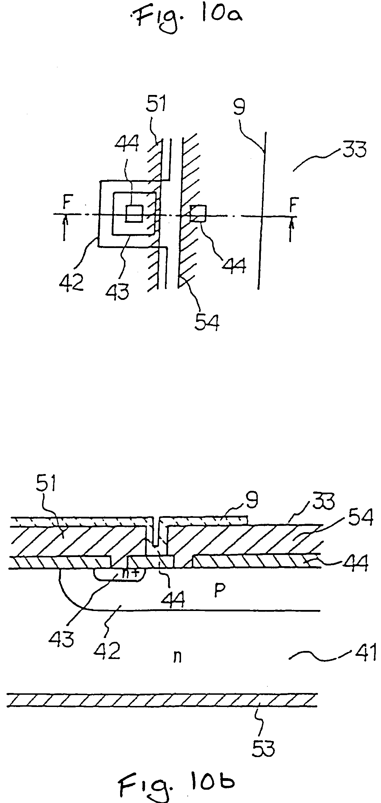

Figures 10a and 10b show an embodiment in which the anode region is formed on the extended portion of the base region 42. The anode electrode 54 makes contact with the base region 42 at a position close to the transistor section. The present invention can therefore be applied not only to the above-mentioned bipolar transistor, but also to other bipolar-type semiconductor elements.

Using the teaching of the present invention, the current flowing into the parasitic diodes to be detected for the purpose of adjusting the switching timing at a commutation can be detected by means of forming sensing diodes of the same configuration on the same semiconductor substrate, and taking out and measuring the current from another electrode connected to the sensing diodes. This type of arrangement makes it possible to determine the timing with less loss, and is therefore more suitable for MOS-type or bipolar-type semiconductor elements of a semiconductor converter device.

## Claims

1. A semiconductor element characterised in that a first region of a first conduction type is formed on a semiconductor substrate, while a second region of a second conduction type is formed selectively in the surface layer of the first region, and an electrode that makes contact with at least the second region is disposed on the surface of the semiconductor substrate, whereby a third region with the same conduction type, impurity concentration and depth as in the case of the second region is formed selectively on the surface layer of the semiconductor substrate, while another electrode that makes contact with the third region is formed on the surface of the semiconductor substrate.

2. A semiconductor element as claimed in Claim 1, characterised in that a fourth region of the first conduction type is formed on the surface layer of the second region, and gate electrodes arranged on the second region in the part located between the first region and the fourth region via an insulation film and a main electrode, which makes contact commonly with the first region and the third region, are disposed.

3. A semiconductor element as claimed in Claim 1, characterised in that electrodes respectively making contact with the first region and the second region are disposed on the surface of the semiconductor substrate.

4. A semiconductor device substantially as herein described.
